Europäisches Patentamt

European Patent Office

Office européen des brevets

(19)

(11) Veröffentlichungsnummer: **0 324 743**
**B1**

(12) **EUROPÄISCHE PATENTSCHRIFT**

(45) Veröffentlichungstag der Patentschrift: **23.05.90**

(51) Int. Cl.⁵: **H 01 L 29/72**

(21) Anmeldenummer: **87905597.8**

(22) Anmeldetag: **02.09.87**

(86) Internationale Anmeldenummer:
**PCT/DE87/00397**

(87) Internationale Veröffentlichungsnummer:
**WO 88/02554 07.04.88 Gazette 88/08**

(54) **HOCHFREQUENZ-LEISTUNGS-TRANSISTOR IN BIPOLAR-EPITAXIAL-TECHNIK.**

(30) Priorität: **27.09.86 DE 3632943**

(43) Veröffentlichungstag der Anmeldung:
**26.07.89 Patentblatt 89/30**

(45) Bekanntmachung des Hinweises auf die
Patenterteilung:
**23.05.90 Patentblatt 90/21**

(84) Benannte Vertragsstaaten:
**DE FR GB IT**

(56) Entgegenhaltungen:
**EP-A-0 132 614**
**GB-A-2 051 475**

**EDN - Electric Design News, vol.26, No.15, 5
August 1981, (Boston Massachusetts, US),
"High voltage bipolar Darlington provides true
dielectric isolation, page 172**

**H.Schrenk: "Bipolare Transistoren", Springer-
Verlag, Berlin 1978, S. 211**

(73) Patentinhaber: **ROBERT BOSCH GMBH
Postfach 50
D-7000 Stuttgart 1 (DE)**

(72) Erfinder: **CONZELMANN, Gerhard
Wilhelmstr. 37
D-7022 Leinfelden-Echterdingen (DE)**
Erfinder: **PFIZENMAIER, Heinz
Liststr. 6
D-7250 Leonberg (DE)**

EP 0 324 743 B1

## Beschreibung

Stand der Technik

Die Erfindung betrifft einen Hochfrequenz-Leistungstransistor nach der Gattung des Hauptanspruchs.

Hochfrequenz-Transistoren für Leistungs-Endstufen in Hochfrequenz-Verstärkern sind meist in Epitaxial-Technik hergestellt. Gegen die üblicherweise an Masse liegenden Kühlkörper werden sie wegen der guten Wärmeleitfähigkeit bei bekannten Ausführungen mit dünnen Berylliumoxid-Plättchen isoliert. Diese Isolationstechnik ist jedoch nicht nur teuer, sondern auch kritisch in der Handhabung, da Berylliumoxid giftig ist.

Weiterhin ist es bekannt, Transistoren in monolithisch integrierter Technik auszuführen, wobei die einzelnen Komponenten einer derartigen Halbleiteranordnung gegeneinander und gegen das Substrat mittels Sperrschichten, eventuell auch dielektrischen Schichten aus SiO$_2$, isoliert sind.

Mit zunehmender Betriebsfrequenz steigen jedoch die Verluste der Sperrschichtisolierung, da die sich bildenden Sperrschichtkapazitäten mit ohmschen Bahnwiderständen behaftet sind.

Aus der GB-A-2 051 475 ist weiterhin ein Hochfrequenz-Leistungstransistor nach der Gattung des Hauptanspruchs bekannt, bei dem das Substrat gegenüber der an der zweiten Hauptoberfläche des Siliziumplättchens angebrachten Metallisierung bzw. gegenüber dem dort angebrachten Kühlkörper durch eine Sperrschicht elektrisch isoliert ist. Aber auch diesem Transistor sind in seiner Anwendung Grenzen gesetzt, weil sich bei zunehmender Betriebsfrequenz die Sperrschichtkapazität der Substratdiode mit ihrem Verluste erzeugenden Reihenwiderstand in zunehmendem Maße störend bemerkbar macht.

Vorteile der Erfindung

Der erfindungsgemäße Hochfrequenz-Leistungstransistor mit den kennzeichnenden Merkmalen des Hauptanpruchs hat demgegenüber den Vorteil, daß durch die mindestens eine hochdotierte Schirmelektrodenzone, die mit dem Substrat einen pn-Übergang bildet, eine zusätzliche, der ursprünglich vorhandenen Substratdiode mit entgegengesetzter Polung in Reihe geschaltete Substratdiode eingeführt wird, mit der die bei höherer Betriebsfrequenz sich zunehmend störend bemerkbar machende Wirkung der ursprünglich vorhandenen Substratdiode weitgehend eliminiert wird. Weitere Vorteile ergeben sich aus den Unteransprüchen 2 bis 12 und aus der Beschreibung.

Zeichnung

Die Erfindung wird nachfolgend anhand der Zeichnung näher erläutert. Es zeigen:

Fig. 1 das Ersatzschaltbild eines bekannten bipolaren, monolithisch integrierten Hochfrequenz-Transistors,

Fig. 2 das Ersatzschaltbild eines monolithisch integrierten Hochfrequenz-Transistors mit erfindungsgemäß zusätzlich eingeführter Substratdiode,

Fig. 3 das Ersatzschaltbild eines monolithisch integrierten Hochfrequenz-Transistors, bei dem über der Epitaxie eine durch Oxid isolierte, an Masse angeschlossene Metallisierung vorgesehen ist,

Figur 4 die Draufsicht auf eine monolithisch integrierte Schaltung eines Hochfrequenz-Transistors,

Figur 5 den an sich bekannten Schnitt AB der in Figur 4 dargestellten Anordnung und

Figur 6 einen Schnitt entsprechend dem Schnitt AB der in Figur 4 dargestellten Anordnung, jedoch mit einer erfindungsgemäß eindiffundierten, als Schirmelektrodenzone dienenden Kollektoranschlußdiffusionszone und Emitterzone anstelle der Isolierungsdiffusion nach Figur 5.

Beschreibung der Erfindung

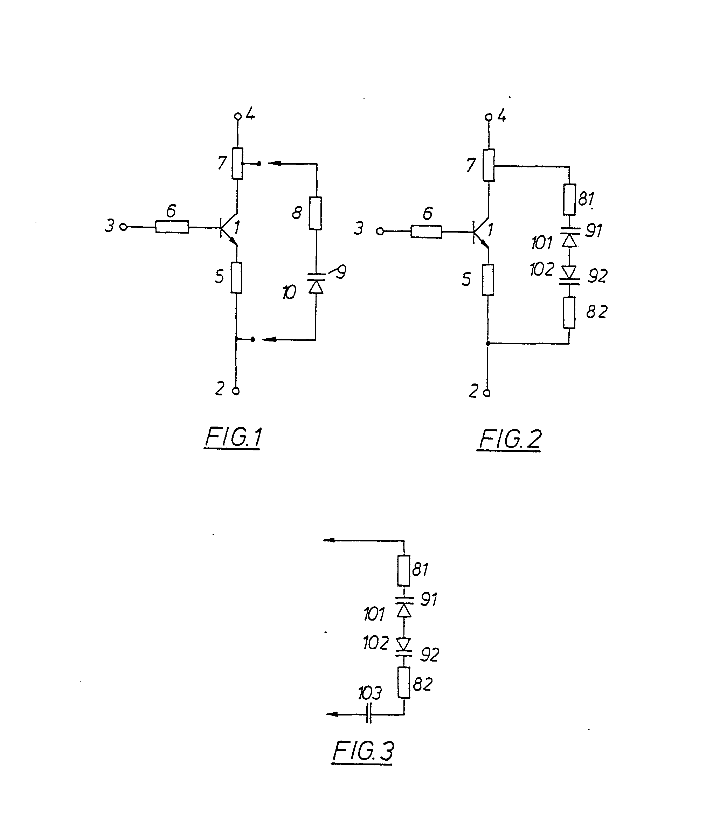

Figur 1 zeigt eine Ersatzschaltung eines bekannten Hochfrequenz-Transistors 1 mit Emitteranschluß 2, Basisanschluß 3 und Kollektoranschluß 4. In den Anschlußleitungen sind die Bahnwiderstände 5, 6 und 7 angegeben. Der Emitterbahnwiderstand 5 ist meistens durch zusätzliche Stabilisierungswiderstände vergrößert, die jedem Teilemitter zugeordnet sind. Im vorliegenden Ersatzschaltbild wurde jedoch auf die Darstellung derartiger weiterer Komponenten ebenso wie auf die Darstellung von Induktivitäten und parasitären Kapazitäten verzichtet.

Wird der Hochfrequenz-Transistor 1 in monolithisch integrierter Technik ausgeführt, so erscheint zusätzlich die Sperrschichtkapazität 9 der Substratdiode 10 mit ihrem Verluste erzeugenden Reihenwiderstand 8.

Die Sperrschichtkapazität 9 der Substratdiode 10 und die Verluste im Reihenwiderstand 8 lassen sich nun durch eine von den üblichen Strukturen monolithisch integrierter Schaltungen abweichende Struktur verringern. Das Prinzip hierzu ist in Figur 2 dargestellt. Es wird zusätzlich eine Diode erzeugt, die der ursprünglich vorhandenen Substratdiode mit entgegengesetzter Polung in Reihe geschaltet ist, Dadurch entsteht die Ersatzschaltung nach Figur 2, wobei aus der ursprünglichen Substratdiode 10 die neue Substratdiode 101 mit ihrer Sperrschichtkapazität 91 und ihrem Reihenverlustwiderstand 81 geworden ist. Durch diese Änderung sind Reihenwiderstand 81 und Kapazität 91 der Substratdiode 101 näherungsweise gleich groß geblieben wie bei der ursprünglichen Substratdiode 10. Die in Reihe dazu liegende weitere Diode 102 besitzt die Sperrschichtkapazität 92 und den Reihenwiderstand 82. Sie setzt sich aus unterschiedlichen Teildioden zusammen. Es gilt, ihre Kapazität 92 klein zu halten gegen die Substratkapazität 91. Je kleiner die Kapazität 92 ist, desto geringer werden die Verluste im Substrat, desto mehr entspricht jedoch auch das Substratpotential hochfrequenzmäßig dem Kollektorpotential.

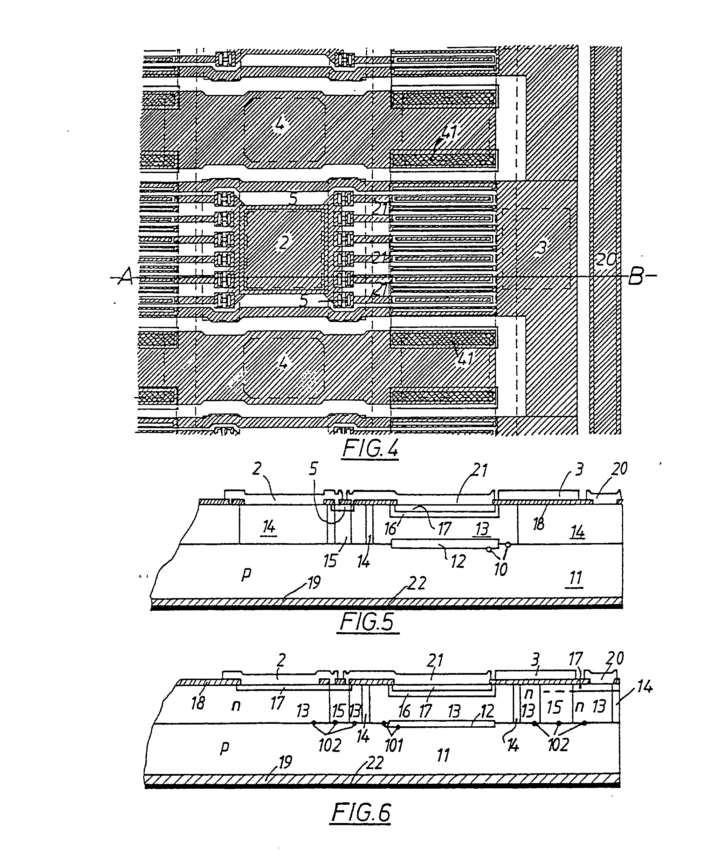

Erzeugt wird die Diode 102 dadurch, daß die von der oberen Hauptebene ausgehenden, sich in das Silizium erstreckenden hochdotierten und auf Massepotential liegenden p-Zonen 14 (Figur 5) durch n-dotierte Zonen 13, 15, 17 ersetzt werden (Figur 6), wobei die Zonen 15 und 17 erfindungsgemäß hochdotierte Schirmelektrodenzonen darstellen.

Liegt über der Epitaxie eine durch Oxid isolierte, an Masse angeschlossene Metallisierung, so gilt das in Figur 3 dargestellte Ersatzschaltbild. Der Reihenschaltung der Substratdiode 101 und der Diode 102 liegt noch die Oxidkapazität 103 in Reihe, deren Verlustwiderstand gegenüber den Widerständen 81, 82 zu vernachlässigen ist. Analog gilt dasselbe für die untere Hauptfläche zwischen Substrat und Kühlkörper.

Im Frequenzbereich von etwa 500 MHz bis 1000 MHz wirken die verschiedenen Ausführungsformen hauptsächlich durch die Reihenschaltung der zusätzlichen Kapazitäten 92 bzw. 92 und 103.

Figur 4 zeigt die Draufsicht auf den Ausschnitt eines Hochfrequenztransistors, wobei die Figuren 5 und 6 zugehörige Schnitte entlang der Schnittlinie AB zeigen.

Wie bereits ausgeführt, sind mit den Bezugszahlen 2, 3, 4 die Anschlüsse von Emitter, Basis und Kollektor gekennzeichnet. In den Zuleitungen zu den Teilemittern sind Widerstände 5 als Stabilisierungswiderstände eingebracht, wobei Verbindungsleitungen 21 von den Widerständen 5 zu den Emittern verlaufen. Außerdem ist am Rand eine metallische Abschirmung 20 vorgesehen.

In der Schnittdarstellung (Figur 5, Figur 6) ist das p-dotierte Substrat 11, der Buried-Layer 12, die darauf abgeschiedene n-dotierte Epitaxie 13, die eindiffundierte Isolierung 14, die Kollektoranschlußdiffusionszone 15, die Basiszone 16 und die Emitterzone 17 ersichtlich.

Die an der oberen Hauptebene austretenden pn-Übergänge sind mit der in dieser Darstellung mit einheitlicher Dicke gezeichneten Oxidschicht 18 abgedeckt. Auf dieser Oxidschicht sind die metallischen Anschlüsse bzw. Verbindungen wie Emitteranschluß 2, Verbindungsleitungen 21, Basisanschluß 3 und Abschirmung 20 angeordnet. Kontakte zu den darunterliegenden Diffusionszonen bestehen in den Oxidfenstern. Auf der unteren Hauptebene des Substrates 11 befindet sich eine Metallisierung 22 auf einer isolierenden Schicht 19, die als dielektrische Schicht bzw. Sperrschicht ausgebildet sein kann.

Die Substratdiode 10 von Figur 1 wird gebildet von der Grenzfläche des Kollektorraums 12, 13 gegen das Substrat II. Die kapazitive Rückwirkung des Kollektors auf den Basisanschluß 3 wird durch die freiliegende niederohmige Diffusion 14, die über die Anschlußleitung 20 mit Masse verbunden ist, drastisch reduziert. Die Emitter-Widerstände 5 können mit der Emitterdiffusion 17, der Kollektoranschlußdiffusion 15 und eventuell auch noch parallelgeschaltet dem Buried-Layer 12 erzeugt werden.

Figur 6 zeigt eine erfindungsgemäße Ausgestaltung der in Figur 5 dargestellten Anordnung. Die mit den an Masse liegenden Anschlüssen 2, Abschirmung 20 verbundenen großflächigen Gebiete 14 von Figur 5, die eine Isolierungsdiffusion bilden, sind bei der Ausführung gemäß Figur 6 aufgelöst und durch die entgegengesetzt dotierte Epitaxie 13 und die Kollektoranschlußdiffusion 15 mit teilweise darüberliegendem Emitter 17 ersetzt, wobei die Zonen 15 und 17 hochdotierte Schirmelektrodenzonen darstellen. Aus der Substratdiode 10 wurde die im wesentlichen gleichartige Substratdiode 101. Zwischen den metallischen Bereichen 2, 20 und dem Substrat 11 befinden sich jetzt n-dotierte Gebiete, wodurch die weitere Diode 102 entsteht. Diese ist der Substratdiode 101 mit entgegengesetzter Polung in Reihe geschaltet, so daß der kapazitive Verschiebestrom kleiner wird und damit auch die Verluste in den ohmschen Bahngebieten.

Ebenso wirksam ist eine zwischen der mit Metall bzw. mit einem Kühlkörper verbundenen Metallisierung 22 und dem Substrat 11 sich bildende Sperrschicht, Diese kann auf der unteren Hauptebene des Substrats 11 als dielektrische Schicht 19 aufgebracht sein.

**Patentansprüche**

1. Monolithisch integrierter Hochfrequenz-Leistungstransistor (1) in Bipolar-Epitaxialtechnik, bei dem die Basiszone (16) von einer ersten Hauptoberfläche eines Siliziumplättchens aus in einen wenigstens teilweise durch Isolierungsdiffusionszonen (14) elektrisch isolierten Bereich der hochohmigen Epitaxial-Schicht (13) und die Emitterzone (17) in die genannte Basiszone (16) eindiffundiert sind,

bei dem der Kollektor durch den verbleibenden Teil des Bereichs der Epitaxial-Schicht (13) sowie durch eine unterhalb der Epitaxial-Schicht (13) liegende niederohmige Kollektorzone (12) gebildet wird, die in einem entgegengesetzt dotierten hochohmigen Substrat (11) eingebettet ist,

bei dem die Emitter-, Basis- und Kollektoranschlüsse (2, 3, 4) an der ersten Hauptoberfläche des Siliziumplättchens liegen,

bei dem der Kollektoranschluß (4) über eine durch die Dicke der Epitaxial-Schicht (13) reichende niederohmige Kollektoranschlußdiffusionszone (15) vom gleichen Leitungstyp wie die Epitaxial-Schicht (13) mit der Kollektorzone (12) verbunden ist und bei dem an einer zweiten Hauptoberfläche des Siliziumplättchens, die der ersten Hauptoberfläche gegenüberliegt, eine Metallisierung (22) und/oder ein Kühlkörper angebracht ist, dadurch gekennzeichnet,

daß der Hochfrequenz-Leistungstransistor (1) eine Mehrzahl von streifenförmig ausgebildeten Teiltransistoren aufweist, daß in der Basiszone (16) jedes Teiltransistors mehrere Emitterfinger (17) angeordnet sind, wobei der Basiszone (16) und den Emitterfingern (17) Verbindungsleitungen zugeordnet sind, die auf der ersten Hauptoberfläche des Siliziumplättchens zwischen den Kollektoranschlüssen (4) der Teiltransistoren verlaufen, und

daß jeder Teiltransistor innerhalb eines großflächigen Bereiches der Epitaxial-Schicht (13), jedoch außerhalb seines durch die genannten Isolierungsdiffusionszonen (14) begrenzten Kollektorraums mindestens eine hochdotierte Schirmelektrodenzone (15, 17) vom Kollektorleitungstyp aufweist, die über eine an der genannten ersten Hauptoberfläche des Siliziumplättchens liegende Metallisierung (2, 20) hochfrequenzmäßig an Masse gelegt ist, so daß eine Diode (102) entsteht, die mit der zwischen dem Substrat (11) und der Epitaxial-Schicht (13) bzw. Kollektorzone (12) im Kollektorraum gebildeten Substratdiode (101) mit entgegengesetzter Polung in Reihe geschaltet ist, um kapazitive Verluste zu verkleinern.

2. Transistor nach Anspruch 1, dadurch gekennzeichnet, daß die hochdotierte Schirmelektrodenzone (15, 17) sich mindestens teilweise in einen Bereich der Epitaxial-Schicht (13) hinein erstreckt, über dem an der ersten Hauptoberfläche des Siliziumplättchens der zugehörige Basisanschluß (3) des betreffenden Teiltransistors oder eine Basisverbindungsleitung angeordnet ist.

3. Transistor nach Anspruch 1 oder 2, dadurch gekennzeichnet, daß am Umfang des Siliziumplättchens wenigstens teilweise eine Isolierungsdiffusionszone (14) vom Substratleitungstyp in die Epitaxial-Schicht (13) eingebracht ist.

4. Transistor nach einem der Ansprüche 1 bis 3, dadurch gekennzeichnet, daß in an sich bekannter Weise das Substrat (11) gegen die Metallisierung (22) bzw. gegen den Kühlkörper durch wenigstens eine isolierende Zwischenschicht (19) elektrisch isoliert ist.

5. Transistor nach Anspruch 4, dadurch gekennzeichnet, daß als isolierende Zwischenschicht (19) eine Sperrschicht dient.

6. Transistor nach Anspruch 4, dadurch gekennzeichnet, daß die isolierende Zwischenschicht (19) eine Oxid- oder Nitridschicht ist.

7. Transistor nach Anspruch 6, dadurch gekennzeichnet, daß die isolierende Zwischenschicht (19) im Plasma-Verfahren auf der zweiten Hauptoberfläche des Siliziumplättchens abgeschieden ist.

8. Transistor nach einem der Ansprüche 4 bis 7, dadurch gekennzeichnet, daß die isolierende Zwischenschicht (19) von einer Sperrschicht und einer dielektrischen Schicht gebildet ist.

9. Transistor nach einem der Ansprüche 4 bis 8, dadurch gekennzeichnet, daß ein legierungs- oder lötfähiger Belag auf die Zwischenschicht (19) aufgebracht ist.

10. Transistor nach Anspruch 9, dadurch gekennzeichnet, daß Poly-Silizium als legierungsfähiger Belag dient.

11. Transistor nach Anspruch 9, dadurch gekennzeichnet, daß eine Aluminium-Nickel-Schicht, gegebenenfalls mit außen aufgebrachter Goldschicht, als lötfähiger Belag dient.

12. Transistor nach einem der vorhergehenden Ansprüche, dadurch gekennzeichnet, daß die an der zweiten Hauptoberfläche des Siliziumplättchens angebrachte Metallisierung (22) bzw. der dort angebrachte Kühlkörper hochfrequenzmäßig an Masse gelegt ist.

**Revendications**

1. Transistor de puissance haute fréquence (1) intégré, monolithique, réalisé selon la technique épitaxiale bipolaire,

dans lequel la zone de base (16) est diffusée à partir d'une première surface principale d'une plaquette de silicium dans une zone au moins partiellement isolée électriquement par des zones de diffusion d'isolation (14) de la couche épitaxiale fortement ohmique (13) et dont la zone d'émetteur (17) est diffusée dans la zone de base (16),

le collecteur étant formé par la partie résiduelle de la zone de la couche épitaxiale (13) ainsi que par une zone de collecteur (12) faiblement ohmique située endessous de la couche épitaxiale (13), zone de collecteur qui est noyée dans un support (11), fortement ohmique et à dopage opposé,

les raccords d'émetteur, de base et de collecteur (2, 3, 4) étant situés au niveau de la première surface principale de la plaquette de silicium,

le raccord de collecteur (4) étant relié par une zone de diffusion de raccordement de collecteur (15) de même type de conduction que la couche épitaxiale (13), et traversant l'épaisseur de la couche épitaxiale (13) pour être relié à la zone de collecteur (12) et une seconde surface principale de la plaquette de silicium en regard de la première surface principale comporte une métallisation (22) et/ou un radiateur, transistor caractérisé en ce que:

le transistor de puissance haute fréquence (1) comprend un grand nombre de transistors partiels réalisés en forme de bandes, la zone de base (16) de chaque transistor partiel comportant plusieurs doigts d'émetteur (17), la zone de base (16) et les doigts d'émetteur (17) étant munis de conducteurs de liaison qui passent sur la première surface principale de la plaquette de silicium entre les raccords de collecteur (4) des transistors partiels,

chaque transistor partiel comporte à l'intérieur d'une zone de grande surface de la couche épitaxiale (13), mais toutefois à l'extérieur de son espace de collecteur délimité par les zones de diffusion d'isolation (14) ci-dessus, au moins une zone d'électrode-écran (15, 17) fortement dopée, ayant le type de conductivité du collecteur, zone qui est mise à la masse pour les hautes fréquences par l'intermédiaire d'une métallisation (2, 20) prévue sur la première surface principale de la plaquette de silicium, pour former une diode (102) qui est branchée en série sur la diode de support (101) formée dans l'espace du collecteur entre le support (11) et la couche épitaxiale (13) ou la zone de collecteur (12), mais avec une polarité opposée pour diminuer les pertes capacitives.

2. Transistor selon la revendication 1, caractérisé en ce que la zone d'électrode-écran, fortement dopée (15, 17) s'étend au moins partiellement dans la zone de la couche épitaxiale (13), zone au-dessus de laquelle se trouve, au niveau de la première surface principale de la plaquette de silicium, le raccord de base (3) correspondant du transistor partiel correspondant ou un conducteur de liaison de base.

3. Transistor selon la revendication 1 ou 2, caractérisé en ce qu'à la périphérie de la plaquette de silicium, on a prévu au moins partiellement une zone de diffusion d'isolation (14) ayant le type de conductivité du substrat dans la couche épitaxiale (13).

4. Transistor selon l'une des revendications 1 à 3, caractérisé en ce que de manière connue en soi, le support (11) est isolé électriquement vis-à-vis de la métallisation (22) ou du radiateur par au moins une couche intermédiaire isolante (19).

5. Transistor selon la revendication 4, caractérisé en ce que la couche de barrage est la couche intermédiaire (19) isolante.

6. Transistor selon la revendication 4, caractérisé en ce que la couche intermédiaire isolante (19) est une couche d'oxyde ou de nitrure.

7. Transistor selon la revendication 6, caractérisé en ce que la couche intermédiaire isolante (19) est déposée selon le procédé par plasma sur la seconde surface principale de la plaquette de silicium.

8. Transistor selon l'une des revendications 4 à 7, caractérisé en ce que la couche intermédiaire isolante (19) est formée par une couche de barrage et une couche diélectrique.

9. Transistor selon l'une des revendications 4 à 8, caractérisé en ce qu'un revêtement d'alliage ou de brasage est prévu sur la couche intermédiaire (19).

10. Transistor selon la revendication 9, caractérisé en ce que le polysilicium constitue un revêtement susceptible d'être allié.

11. Transistor selon la revendication 9, caractérisé en ce qu'une couche aluminium-nickel, le cas échéant avec une couche d'or, extérieure, formant le revêtement de brasage.

12. Transistor selon l'une des revendications précédentes, caractérisé en ce que la métallisation (22) prévue sur la seconde surface principale de la plaquette de silicium ou le radiateur prévu à cet endroit sont mis à la masse pour les hautes fréquences.

## Claims

1. Monolithically integrated high-frequency power transistor (1) in bipolar epitaxial technology,

in which, starting from a first main surface of a silicon chip, the base zone (16) is diffused into an area of the high-impedance epitaxial layer (13), which area is at least partially electrically insulated by insulation diffusion zones (14), and the emitter zone (17) is diffused into the said base zone (16),

in which the collector is formed by the remaining part of the area of the epitaxial layer (13) and by a low-impedance collector zone (12) lying beneath the epitaxial layer (13), which collector zone is embedded in an oppositely doped high-impedance substrate (11),

in which the emitter, base and collector terminals (2, 3, 4) are connected to the first main surface of the silicon chip,

in which the collector terminal (4) is connected to the collector zone (12) via a low-impedance collector terminal diffusion zone (15) of the same conductor type as the epitaxial layer (13) and extending through the thickness of the epitaxial layer (13) and in which a metallization (22) and/or a heat sink is applied to the silicon chip's second main surface lying opposite the first main surface, characterized in that the high-frequency power transistor (1) has a plurality of strip-shaped subtransistors, in that a plurality of emitter fingers (17) are arranged in the base zone (16) of each subtransistor, the base zone (16) and the emitter fingers (17) being associated with connecting lines which extend on the first main surface of the silicon chip between the collector terminals (4) of the subtransistors, and in that each subtransistor has, within a large area of the epitaxial layer (13), but outside its collector space delimited by the said insulation diffusion zones (14), at least one heavily doped shield electrode zone (15, 17) of the collector conductor type, which shield electrode zone is high-frequency earthed via a metallization (2, 20) connected to the said first main surface of the silicon chip so that a diode (102) is produced which is connected in series with opposite polarity to the substrate diode (101) formed between the substrate (11) and the epitaxial layer (13) or collector zone (12) in the collector space in order to reduce capacitive losses.

2. Transistor according to Claim 1, characterized in that the heavily doped shield electrode zone (15, 17) extends at least partially into an area of the epitaxial layer (13) over which the respective base terminal (3) of the relevant subtransistor or a base connecting line is arranged at the first main surface of the silicon chip.

3. Transistor according to Claim 1 or 2, characterized in that on the perimeter of the silicon chip an insulation diffusion zone (14) of the substrate conductor type is at least partially built into the epitaxial layer (13).

4. Transistor according to one of Claims 1 to 3, characterized in that in a way known per se the substrate (11) is electrically insulated from the metallization (22) or from the heat sink by at least one insulating intermediate layer (19).

5. Transistor according to Claim 4, characterized in that a depletion layer serves as the insulating intermediate layer (19).

6. Transistor according to Claim 4, characterized in that the insulating intermediate layer (19) is an oxide or nitride layer.

7. Transistor according to Claim 6, characterized in that the insulating intermediate layer (19) is deposited using the plasma method onto the second main surface of the silicon chip.

8. Transistor according to one of Claims 4 to 7, characterized in that the insulating intermediate layer (19) is formed by a depletion layer and a dielectric layer.

9. Transistor according to one of Claims 4 to 8, characterized in that an alloyable or solderable coating is applied to the intermediate layer (19).

10. Transistor according to Claim 9, characterized in that polysilicon serves as the alloyable coating.

11. Transistor according to Claim 9, characterized in that an aluminium-nickel layer, if desired with a gold layer applied on the outside, serves as the solderable coating.

12. Transistor according to one of the preceding claims, characterized in that the metallization (22) applied to the second main surface of the silicon chip or the heat sink mounted on it is high-frequency earthed.

4

7

3

6

1

8

5

10

9

2

_FIG.1_

4

7

3

6

1

81

101

91

102

92

5

82

2

_FIG.2_

81

101

91

102

92

103

82

_FIG.3_

1

EP 0 324 743 B1

FIG.4

FIG.5

FIG.6

2